# EUROPEAN PATENT SPECIFICATION

(11) **EP 1 573 828 B1**
(45) Date of publication and mention of the grant of the patent: **26.11.2008**
(21) Application number: 03814051.3
(22) Date of filing: 16.12.2003
(51) Int. Cl.: H01L 39/24, B23P 17/00, H02G 15/34, H01B 12/00, H01G 9/145, B23B 15/00

(54) **PRODUCTION OF ELECTROLYTIC CAPACITORS AND SUPERCONDUCTORS**
HERSTELLUNG VON ELEKTROLYTKONDENSATOREN UND SUPRALEITERN
PRODUCTION DE CONDENSATEURS ELECTROLYTIQUES ET DE SUPRACONDUCTEURS

(30) Priority: 17.12.2002 US 434039 P
(43) Date of publication of application: 14.09.2005
(73) Proprietor: COMPOSITE MATERIALS TECHNOLOGY, Inc., Shrewsbury, MA 01545 (US)
(72) Inventor: WONG, James, Wayland, MA 01788 (US)
(74) Representative: Sulzbach, Werner
(86) International application number: PCT/US2003/040080
(87) International publication number: WO 2004/059754

(56) References cited:
- WO-A-00/63456
- US-A- 3 800 061
- US-A- 5 034 857
- US-A- 5 223 348
- US-A- 5 245 514
- US-A- 5 869 196
- BEST K J ET AL: "Anisotropy of optimized and not optimized technical NbTi superconductors" IEEE TRANSACTIONS ON MAGNETICS USA, vol. MAG-15, no. 1, January 1979 (1979-01), pages 765-767, XP009063385 ISSN: 0018-9464
- BEST K J ET AL: "Anisotropy of the critical current in solid solution superconductor NbTi" IEEE TRANSACTIONS ON MAGNETICS USA, vol. MAG-15, no. 1, January 1979 (1979-01), pages 395-397, XP009063384 ISSN: 0018-9464

## Description

The present invention as defined by claim 1 is directed to the production of electrical devices, e.g. electrolytic capacitors and superconducting materials based on the use of valve metals such as tantalum and niobium and its alloys. In work done previously by the assignee of this patent application there have been described developments wherein filaments of refractory metals such as tantalum and niobium are extruded in a softer metal such as copper while encased in a surrounding sleeve of the valve metal e.g. tantalum or niobium. Utilizing this technology filaments of either tantalum or niobium have been drawn to very small diameters while in the copper matrix and while surrounded by the constraining layer of tantalum or niobium. The copper is leached out from between the very fine filaments in the final product while the fine filaments are constrained in a manageable bundle by the outer constraining acid resistant layer of tantalum or niobium. This technology is more fully described in our prior parent U.S. patent number 5,869,196 and our PCT Application Serial No. PCF/US03/24724, filed August 7,2003.

In the present invention there is an improvement over the process described in the '196 patent above wherein the constrained mass of small fine tantalum or niobium filaments is subjected to a rolling deformation which flattens the individual small filaments so that each wire has aspect ratio of at least 5:1. This relatively high aspect ratio in the final compressed and flattened individual fine filaments has the following major advantages. When the Nb is reacted to form Nb₃Sn, currently, round Nb filaments require in excess of 180 hours at 700°C to completely react 4-micron filaments. The same filament rolled to an aspect ratio of 5:1 will be only 1.26 µm thick and can be fully reacted using considerably shorter times. By reducing the time and distance for reaction, finer grain size and more importantly, uniform Nb₃Sn are obtained and as a result, higher current densities as well.

A flat conductor is easier to wind into a magnet and it has higher filling factor where the void space when a round conductor is used is eliminated. Another important consideration is that thin conductors are more ductile and can be wound into magnets of small diameters. A reacted Nb₃Sn; flattened to an aspect ratio of 5:1, with a thickness of 0.02mm can be bent around a radius of 5cm without fracturing the wire. This offers the possibility of reaction and winding, similar to present day ductile NbTi magnets.

An unexpected discovery has been that the improvements for superconductor have been shown to be even more important for capacitors. The filament size, its number, spacing and surface area/unit volume are exactly the same critical designs parameters for both applications. In the case for superconductors, the entire Nb filament is converted to superconducting Nb₃Sn. For capacitors, the surface of the Nb filament is converted to Nb₂0₅, the dielectric compound for capacitors use. In fact, with only minor size and shape adjustment, the wire can be used as either a superconductor or as an anode for solid Nb electrolytic capacitors. Confirmation of the dual use possibility of this invention are further demonstrated by two recent publications, Alternative Materials for Electrolytic Capacitors by Dr. K. Reichert, T. L C. Bulletin, No. 109 March 2002 page 2-3, and Powder for Capacitor, Sintered Body Thereof and Capacitor Using the Sinter Body PCT/JP01/10484 OMORI, Kazuhiro, 6 June 2002, where Ta and Zr alloys of Nb, used for superconductors, has been shown to have excellent capacitor properties as well.

A process of fabrication of a constrained filament niobium-based superconductor composite is disclosed by WO 00/63456 A2.
Fig. 1 is a schematic depiction of the primary billet used in the present invention. Fig. 1a shows a transverse cross section. Fig. 1b is a cutaway view revealing the longitudinal disposition of the billet components.
Fig. 2 is a flow-chart describing the steps followed in the execution of the process.
Fig. 3 is a schematic depiction of the transverse cross section of the secondary billet used in the process of the present invention. Fig. 3a shows the billet used in the process of the present invention, wherein the sheath is circumferentially continuous. Fig. 3b shows the billet used in another embodiment wherein the sheath contains a gap that renders it circumferentially discontinuous, but overlapping. Fig. 3c is similar to Fig. 3b in that the sheath is shown as being circumferentially discontinuous, but no overlap is present.
Fig. 4 is a schematic depiction of a product of the process of the present invention. Fig. 4a shows the product as a cylindrical body. Fig. 4b shows the product after shaping into a rectangular body.

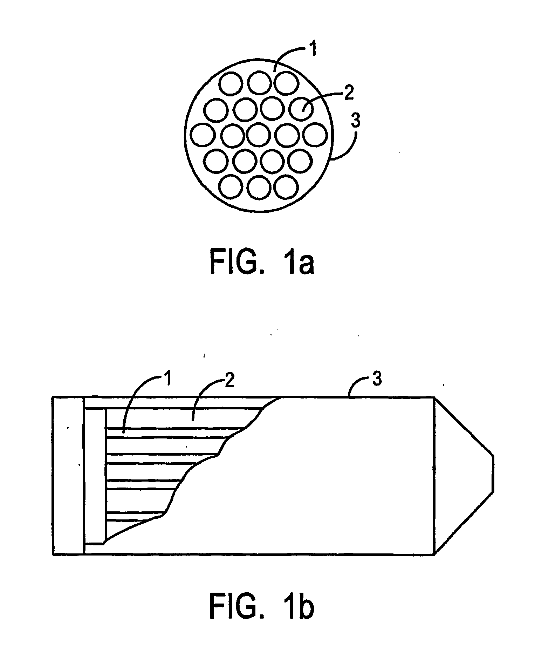

In the preferred embodiment of the present invention for making capacitor anodes, the process begins with niobium or tantalum rods that are inserted into holes drilled longitudinally into a copper billet, shown schematically in Figs. 1a and 1b. Referring to the Figures, the copper forms a matrix 1 which separates the tantalum or niobium rods 2. The assembly as a whole forms the primary billet 3. As Fig. 1b indicates, the rods run longitudinally through the body of the billet and are substantially parallel. After assembly, a copper nose and tail are welded onto the primary billet, and the billet is then evacuated and sealed. At this point the primary billet may optionally be hot or cold isostatically pressed (HIP'd or CIP'd) in order to collapse any void space, thereby promoting filament uniformity. If the billet is hot or cold isostatically pressed, it will usually be machined on a lathe afterwards in order to restore a cylindrical shape.

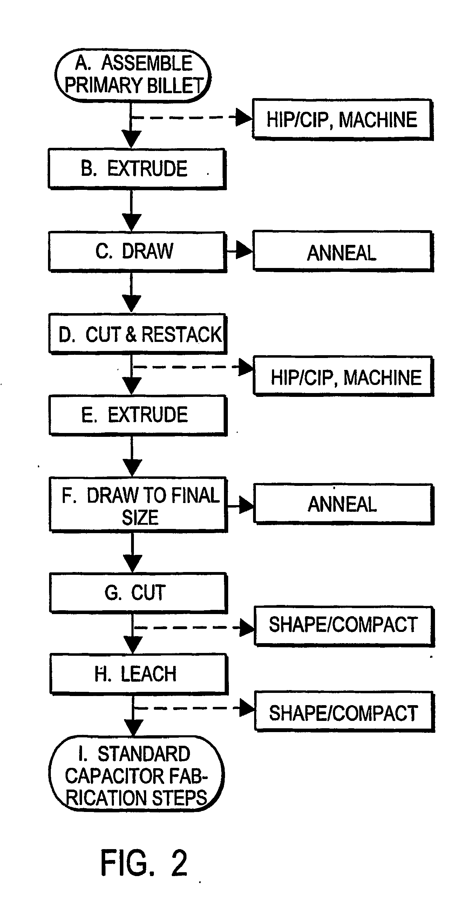

The primary billet, containing the niobium or tantalum rods in a copper matrix, is processed in accordance with the flow-chart of Fig. 2. The billet is extruded at elevated temperature at a diameter reduction ratio of approximately 6:1. The resulting rod is cropped, and the rod is drawn down to restack diameter. As indicated in Fig. 2, annealing may optionally be performed during drawing should the wire become too stiff or breakage occurs. Annealing temperatures for tantalum and niobium are well known in the art they are typically in the range of 900°C.

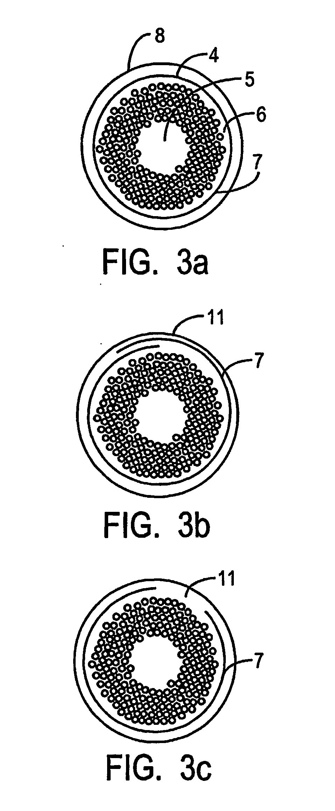

At restock diameter, the composite wire is cut into lengths for assembly into the secondary billet. The secondary billet transverse cross section is shown schematically in Fig. 3a. The subelements 4 made from the primary billet are stacked together with copper rods. The copper rods are used to form a copper core 5, and an outer annulus 6. Both the core and the outer annulus are provided in order to make leaching of the final composite less difficult. Outside the assembly of the subelements and copper rods is a layer of tantalum sheet 7. The sheet is the same length as are the rods and it completely surrounds the filament array. The sheet thickness is comparable to the diameter of the niobium or tantalum filaments within the subelements. Outside the cylinder of niobium or tantalum sheet is an outer copper can 8.

The secondary billet is assembled, a nose and tail are welded into place, and the billet is evacuated and sealed. The sealed billet is optionally prepared for extrusion by hot or cold isostatic pressing in order to collapse any void space within the billet and to promote filament uniformity. After isostatic pressing, the secondary billet is machined to fit the extrusion liner. The billet is then extruded at elevated temperature at a diameter reduction ratio of 6:1.

The extruded rod is cropped, and the rod is then drawn to a diameter where the niobium or tantalum filament diameter is 5 µm or less. Again, as indicated in Fig. 2, annealing steps may be employed if necessary. At final size, the composite wires is cut into short lengths as required, preferably not less than 1.5 times the final wire diameter. The cutting process must be as "clean" as possible, by which is meant that smearing or pinching at the ends of the cut sections must be kept to a minimum. If the cutting does not provide sufficiently clean ends, this will interfere with the subsequent leaching process. Clean cut ends may be achieved through the use of a high-precision impact cutoff machine.

The cut sections are immersed in a solution of nitric acid and water. A suitable solution would be one part nitric acid to one part water, but other concentrations of nitric acid can be employed if required. The sections are immersed for a period of time sufficient for the acid to fully leach out the filaments and the sheath. The total time will depend primarily upon the composite wire diameter and length, with smaller diameters and greater lengths requiring longer times. This is due to the fact that the acid can only penetrate through the ends of the cut sections. Narrow openings and long distances do not lend themselves to rapid etching.

In regard to the leaching process, it is an essential feature of this embodiment of the present invention that the secondary billet is provided with a copper core 5 and a copper annulus 6 (Fig. 3 a). During the leaching process, the copper core and annulus etch away much more rapidly than does the copper separating the filaments, since the filaments are comparatively tightly spaced. As a result, the acid eventually surrounds the annulus of filaments, and can then attach the filament matrix from all directions, rather than just from the ends of the cut sections. The design of the secondary billet thus greatly improves the efficiency of the leaching process.

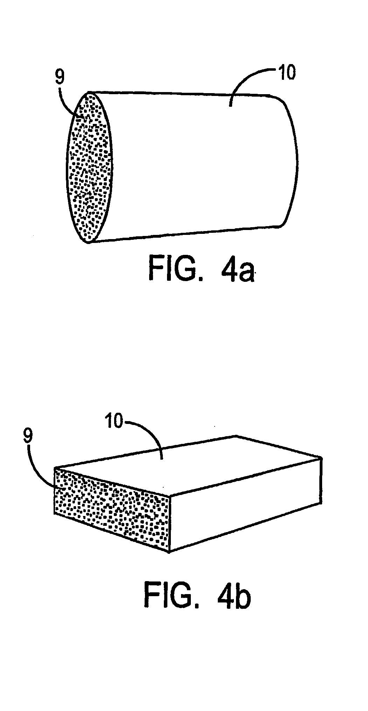

After leaching, one is left with the product, shown schematically in Fig. 4a. It consists of fine filaments (<5 µm diameter) 9, surrounded by a thin tube 10. This product can be made into an anode for an electrolytic capacitor by conventional means, including sintering, anodizing, infiltrating with electrolyte, etc. It may be desirable to shape the product of the present invention by means such as pressing in a die. A rectangular chip can be produced in this manner. Such a chip is illustrated in Fig. 4b. A rectangular chip may be more compatible with current industry standards. The shaping is preferably performed prior to sintering of the product. The shaping may be done either with or without the ductile metal matrix present (see Fig. 2). In addition to shaping, it may be desirable to further compact the product. In such cases, the product is compressed, rather than simply reshaped. Further compaction may be beneficial to electrical continuity with the compact.

Depending upon the degree of electrical continuity and the level of purity within the product of the present invention, it may not be necessary to sinter the product. If sintering is avoided, the process of the present invention will be less expensive. The decision on whether or not to sinter the product will depend primarily upon the requirements of the application.

Another embodiment of the invention employs the secondary billet illustrated schematically in Fig. 3b. The billet is identical to that shown in Fig. 3a except that the layer of niobium or tantalum sheet 7 is not circumferentially continuous, but contains a gap 11. The gap is positioned at an overlap in the sheet, so that the filaments are completely surrounded by the niobium or tantalum layer, much as in the preferred embodiment. A section of copper sheet is inserted into the gap so as to prevent niobium or tantalum to-niobium or tantalum contact in the region of the overlap. Processing of the secondary billet proceeds exactly as described above, including leaching in nitric acid. The gap in the sheath accelerates the leaching process, since the acid can now penetrate from the exterior of the cut sections, as well as from the ends.

Yet another embodiment of the invention employs the secondary billet illustrated schematically in Fig. 3c. This embodiment is similar to that illustrated in Fig. 3b, and described above, except that the sheet 7 does not overlap. The sheet does not fully surround the filaments, leaving the gap 11. Although the sheet does not fully surround the filaments, it does to a substantial extent, so that the filaments are for the most part constrained. Processing of the secondary billet proceeds as described above. Again, the gap in the sheath serves to accelerate the leaching process.

Yet another embodiment of the present invention employs a secondary billet similar to that illustrated in Fig. 3b, except that the copper sheet is circumferentially continuous. The cooper sheet fully encloses the array of filaments in their copper matrix, and then continues for some distance to create the overlap. The overlap is separated from the bulk of the sheath by a section of copper sheet that is inserted into the gap. The secondary billet is processed as in the preferred embodiment of the invention. After the final leaching step, one is left with a number of small bodies wherein the filaments are constrained within the sheath. The overlapping sheet of the secondary billet forms a thin tab that is metallurgically bonded to the sheath as a result of secondary billet processing. A lead wire may be attached to the tantalum tab or the tab itself may be used as a lead wire during anodization and impregnation of the capacitor. The tab may also serve as an electrical contact in final capacitor packaging.

In other embodiments of the invention, all or part of the sheath is made to be perforated or porous so as to accelerate the leaching process while still maintaining the effectiveness of the sheath with regard to constraint of the enclosed filaments.

Patent '196, specifically describes the inclusion of a separate outer sheath of Tantalum or Niobium to further constrain the filament bundle. A major advantage of both processes is illustrated in Figs. 4a and 4b of patent '196, where examples of finished shaped anodes are shown and thus eliminates completely the need to handle and press fine powders.

The ability to shape the anode to almost any shape or form provides the basis for capacitor application. The papers as listed below are relevant to this application.
1. D.A. McLean, The AC Properties of Tantalum Solid Electrolytic Capacitors, journal of the Electro chemical Society January 1961 page 48-56.
2. P.L. Bourgault and J. Batlaan, Low ESR Solid Tantalum Capacitors; Proceeding Electronic Component Conference 1968, page 38-43.
3. S. Hluchan, Powder Geometry and Structural Design of the High Volumetric Efficiency Tantalum Electrolytic Capacitor: IEEE Transaction on Parts, Hybrids, and Packaging, Volume PHP-9, No. 3, September 1973, page 148-155.

McLean shows that the A.G properties of porous tantalum solid electrolytic capacitors are frequency dependent and that the capacitance decreases and internal resistance or ESR increases with increasing frequency. Theoretically, an ideal capacitor would operate with essentially zero ESR. As the ESR increases, heat is generated, possibly leading to capacitor failure, and electrical circuit problems. In Bourgault's equation 9, the dissipation factor or ESR is proportioned to the square of the radius of the capacitor, In other words, the efficiency of the capacitor is size dependent. He concluded that a thin wall anode or hollow tube was the desired shape and as a result, U.S. Patent 3,345,545 was issued. The concept of an ideal anode shape to improve capacitors performance was also confirmed in the paper by Hluchan. An ideal anode would be one where the thickness is that of a foil, somewhere about 25 to 100 µm and a width of approximately 2-10 mm wide. The foil should be porous, and contain a high specific surface area/volume. Most importantly it must be robust and capable of being physically handled when subjected to the processing step necessary to produce finished capacitors. It has been found in our experiments that the chip anode shape of Fig. 4b of my patent '196 can in fact produce the desired foil and is illustrated by Table 1. In table 1, 0.5 and 0.76 mm (0.020" and 0.030") round wires, made according to our patent '857 and '196, were rolled to the indicated thin ribbon dimensions. Billet 33B/30A contains 9/125 filaments and measures 12µ and 18µ in diameter at the 0.5 mm and 0.76 mm (0.020" and 0.030") sizes prior to rolling. As the rolling reduction is increased, the width also substantially increases. Aspect ratio of greater than 40:1 has been obtained. The optimum aspect ratio would generally favor the thinnest foil. Other factors can, however influence the degree of reduction. For example, as the filaments are flattened, they are also closer together and copper removal can become difficult. If the filaments are too thin, then, they can possibly lose capacitance, since they can be totally consumed during the anodization step.

**TABLE 1**

| Sample | Size & Shape | Size/Shape |
|---|---|---|
| 33B/30A | 0.5 mm (0.020") round | 0.76 mm (0.030") round |
| 33B/30A | 0.25 mm x 0.76 mm (0.010 x 0.030") | |
| 33B/30A | 0.15 x 1.2 mm (0.006 x 0.047") | 0.07 x 3.2 mm (0.00285" x .125") |
| 33B/30A | 0.1 x 2 mm (0.004 x 0.079) foil | |

Metallographic studies of the cross-section show that the decreasing thickness, the filament are also flatten and its aspect ratio increases to as much as 10:1, measuring approximately 2 µm x 20 µm wide. It is obvious that the rolling process has increased the available surface area of the filaments significantly and at the same time provide the ideal shape for AC application.

Handling of these highly aspected thin foil can be more difficult after leaching. Some structural support appears to be necessary. This can be accomplished by a simple change in billet design. In place of a uniform array of rods as shown in Fig. 1a, a single large diameter rod is inserted into the center of the billet. This billet, when finally rolled to the desired thickness and with will form a continuous inner foil exactly at the center of the larger foil, surrounded by the outer filaments. It now supports the filaments, provides a common electrical contact, and acts as a convenient location for the anode termination. The central rod should not exceed 20% by area of Cu and can be adjusted as required.

Copper removal is more difficult for these highly compacted foils. The flattened filaments are extremely close together and may even be touching. To insure complete copper removal, a continuous liquid magnesium dipping process can be used to leaching the copper from the foil. Copper is completely soluble in liquid magnesium while Ta and Nb are insoluble. A similar process, used to leach the copper matrix with liquid Sn was shown in our aforesaid U.S. patent application Serial No. 09/532,362. The magnesium matrix can then be easily removed by a combination of vacuum distillation and an acid clean step.

To increase the total capacitance of this foil shape, several foils can be arranged much like that of the MLCC (Multi-Layer Ceramic Capacitor) where layer are stacked together and electrically connected in parallel. This concept is also shown in paper by J. Gerblinger, given at the Symposium on Tantalum and Niobium, San Francisco held October 22, 2002 titled Tantalum Capacitors Today and Tomorrow, pages 329-342. See, in particular, figures 3 and, in which Multi-Anode capacitors designs are shown and are cited as a solution for obtaining minimum ESR performance.

## Claims

1. A process for making superconducting material useful for forming electrolytic devices comprising the steps of :
establishing multiple niobium or tantalum components in a primary billet of a ductile copper matrix;
working the resulting primary billet by a series of reduction steps to form said niobium or tantalum components into a composite wire of niobium or tantalum filaments while in the copper matrix;
cutting and restacking the composite wire around a copper core and surrounding the stack with a porous confining layer to form a secondary billet; and
working the secondary billet through a series of reduction steps;
**characterized in that** working the secondary billet includes rolling the secondary billet in such a way that the individual niobium or tantalum filaments are flattened into ribbons in which each of the ribbons has an aspect ratio of greater than 5:1; and the secondary billet, after working, is cut into sections, and the copper core and copper matrix are leached at least in part.

2. The process of claim 1, **characterized in that** said copper core and copper matrix are leached in an acid leach.

3. The process of claim 1, **characterized in that** the copper core and copper matrix are leached in a liquid metal bath.

4. The process of claim 3, **characterized in that** said liquid metal bath comprises molten magnesium.

5. The process of claim 1, **characterized in that** said porous confining layer contains a gap that renders it circumferentially discontinuous, but overlapping.

6. The process of claim 1, **characterized in that** said porous confirming layer contains a gap that renders it circumferentially discontinuous.

7. The process of claim 1, **characterized in that** the secondary billet is worked by twisting and rolling.

8. The process of claim 1, **characterized in that** the step of cutting and restacking the composite wire includes surrounding the stack with a copper annulus.

## Patentansprüche

1. Verfahren zur Herstellung von supraleitendem Material, das zur Bildung elektrolytischer Vorrichtungen verwendbar ist, mit den folgenden Schritten:
Bereitstellen mehrerer Niob- oder Tantalkomponenten in einem primären Block aus einer streckbaren Kupfermatrix,
Bearbeiten des resultierenden primären Blocks durch eine Reihe von Reduktionsschritten, um die Niob- oder Tantalkomponenten zu einem Verbunddraht aus Niob- oder Tantalfäden zu formen, während sie sich in der Kupfermatrix befinden,
Schneiden und Umstapeln des Verbunddrahts um einen Kupferkern herum und Umhüllen des Stapels mit einer porösen Sperrschicht unter Bildung eines sekundären Blocks, und
Bearbeiten des sekundären Blocks durch eine Reihe von Reduktionsschritten,
**dadurch gekennzeichnet, dass** das Bearbeiten des sekundären Blocks das Walzen des sekundären Blocks umfasst, so dass die einzelnen Niob- oder Tantalfäden zu Bändern flachgedrückt werden, wobei jedes Band ein Seitenverhältnis von mehr als 5:1 hat, und dass der sekundäre Block nach dem Bearbeiten in Abschnitte geschnitten wird und der Kupferkern und die Kupfermatrix zumindest teilweise ausgelaugt werden.

2. Verfahren nach Anspruch 1, **dadurch gekennzeichnet, dass** der Kupferkern und die Kupfermatrix in einer sauren Lauge ausgelaugt werden.

3. Verfahren nach Anspruch 1, **dadurch gekennzeichnet, dass** der Kupferkern und die Kupfermatrix in einem Flüssigmetallbad ausgelaugt werden.

4. Verfahren nach Anspruch 3, **dadurch gekennzeichnet, dass** das Flüssigmetallbad geschmolzenes Magnesium umfasst.

5. Verfahren nach Anspruch 1, **dadurch gekennzeichnet, dass** die poröse Sperrschicht einen Spalt aufweist, der dazu führt, dass sie umfangsmäßig diskontinuierlich aber überlappend ist.

6. Verfahren nach Anspruch 1, **dadurch gekennzeichnet, dass** die poröse Sperrschicht einen Spalt aufweist, der dazu führt, dass sie umfangsmäßig diskontinuierlich ist.

7. Verfahren nach Anspruch 1, **dadurch gekennzeichnet, dass** der sekundäre Block durch Verdrillen und Walzen bearbeitet wird.

8. Verfahren nach Anspruch 1, **dadurch gekennzeichnet, dass** der Schritt des Schneidens und Umstapelns des Verbunddrahts das Umgeben des Stapels mit einem Kupferring umfasst.

## Revendications

1. Procédé de production de matériau supraconducteur utilisé pour façonner des dispositifs électrolytiques, comprenant les étapes suivantes :
établir des composants multiples de niobium ou de tantale dans un lingot primaire d'une matrice de cuivre ductile ;
travailler le lingot primaire résultant par une série d'étapes de réduction pour façonner les composants de niobium ou de tantale pour former un fil composite de filaments de niobium ou de tantale séjournant dans la matrice de cuivre ;
couper et réempiler le fil composite autour d'un noyau de cuivre et entourer la pile d'une couche d'obturation poreuse pour façonner un lingot secondaire ; et
travailler le lingot secondaire par une série d'étapes de réduction ;
**caractérisé en ce que** le travail du lingot secondaire comprend le laminage du lingot secondaire de telle sorte que les filaments individuels de niobium ou de tantale sont aplatis en rubans dans lesquels chaque ruban a un rapport d'allongement supérieur à 5:1 ; et le lingot secondaire, après avoir été travaillé, est coupé en sections, et le noyau de cuivre et la matrice de cuivre sont lixiviés au moins en partie.

2. Procédé selon la revendication 1, **caractérisé en ce que** le noyau de cuivre et la matrice de cuivre sont lixiviés dans un bain de lixiviation acide.

3. Procédé selon la revendication 1, **caractérisé en ce que** le noyau de cuivre et la matrice de cuivre sont lixiviés dans un bain de métal liquide.

4. Procédé selon la revendication 3, **caractérisé en ce que** le bain de métal liquide comprend du magnésium fondu.

5. Procédé selon la revendication 1, **caractérisé en ce que** la couche d'obturation poreuse contient une fente qui la rend discontinue sur la circonférence, mais en se chevauchant.

6. Procédé selon la revendication 1, **caractérisé en ce que** la couche d'obturation poreuse contient une fente qui la rend discontinue sur la circonférence.

7. Procédé selon la revendication 1, **caractérisé en ce que** le deuxième lingot est travaillé par torsion et par laminage.

8. Procédé selon la revendication 1, **caractérisé en ce que** dans l'étape de coupe et de réempilage, le fil composite comprend l'entourage de la pile avec un anneau de cuivre.
